# EUROPEAN PATENT APPLICATION

(11) **EP 4 024 147 A1**
(43) Date of publication of application: **06.07.2022**
(21) Application number: 21150183.8
(22) Date of filing: 05.01.2021
(51) Int. Cl.: G05B 19/042, G05B 23/02, G01H 1/00, G01R 31/34

(54) **SENSOR DEVICE FOR MONITORING ROTATIONAL MACHINERY AND METHOD FOR MONITORING ROTATIONAL MACHINERY**

(71) Applicant: EWA Sensors ApS, 8600 Silkeborg (DK)
(72) Inventor: KÜHNE, Eva, 8600 Silkeborg (DK)
(74) Representative: Zacco Denmark A/S

(57) **Abstract**

The disclosure relates to a sensor device (10) for monitoring rotational machinery (1) having a motor (2). The sensor device is adapted for attachment to a surface of the rotational machinery. The sensor device comprises an outer enclosure with an outer surface.

The sensor device is adapted for monitoring the state of the rotational machinery using a magnetic field sensor (20) configured for measuring a magnetic field during rotation of the rotor, an accelerometer (30) configured for measuring mechanical vibrations during rotation of the rotor and/or a measuring circuit (120) comprising a first sensor element (130) and a second sensor element (140) configured to measure a field during rotation of the rotor.

The sensor device is configured with a data processor arrangement (40) and one or more signalling units (50) in communication with the data processor arrangement.

The data processor arrangement is configured for processing input based on performed measurements and according to a predefined set of rules.

The sensor device is configured to provide a concluded output based on said processing indicating a machine state (510) selected amongst a plurality of machine states.

The disclosure furthermore relates to corresponding methods (700) of monitoring rotational machinery

Also disclosed herein are computer program(s) for carrying out the method acts and a computer-readable medium for storing the computer program(s).

## Description

### Field of disclosure

The disclosure relates to a sensor device for monitoring rotational machinery having a motor. The sensor device is adapted for attachment to a surface of the rotational machinery. The sensor device comprises an outer enclosure with an outer surface.

The sensor device is adapted for monitoring the state of the rotational machinery using a magnetic field sensor configured for measuring a magnetic field during rotation of the rotor, an accelerometer configured for measuring mechanical vibrations during rotation of the rotor and/or a measuring circuit comprising a first sensor element and a second sensor element configured to measure a field during rotation of the rotor.

The sensor device is configured with a data processor arrangement and one or more signalling units in communication with the data processor arrangement.

The data processor arrangement is configured for processing input based on performed measurements and according to a predefined set of rules.

The sensor device is configured to provide a concluded output based on said processing indicating a machine state selected amongst a plurality of machine states.

The disclosure furthermore relates to corresponding methods of monitoring rotational machinery

Also disclosed herein are computer program(s) for carrying out the method acts and a computer-readable medium for storing the computer program(s).

### Background

Today, condition monitoring of machines are widely used with the desire to achieve an efficient operation of the machines in the day-to-day production, for maintenance and service life of the machines.

In particular, equipment that are critical for production or for running a continuous process are preferably monitored on-line.

In combination or alternatively hereto, machines may be inspected regularly in manually inspection rounds, where a plant manager/maintenance staff inspects the plant for the status or condition of equipment, as well as status of production.

Examples of such plants may include process industries, ships and commercial buildings amongst others. At these types of plants, and similar plants, there are large numbers of equipment of different types. In particular, machinery with a rotating member, rotational machinery considered critical for upholding the production are typically monitored continuously on a regular basis.

Rotational machinery considered non-critical for the operation may on the contrary not be automatically monitored. Measurements based on autonomous measurement methods are rarely applied on such machinery. One reason may be that current available methods are based on measurement devices and systems that are fairly expensive, difficult to install, costly to maintain or that measurement data are difficult to interpret.

Examples of such non-critical rotational machinery could be fans, waste-transporting conveyors, pumps e.g. cooling pumps, selected production pumps amongst others.

Thus, a common approach for monitoring of rotational machines, in particular non-critical machines, may still include manually evaluation of any deviations from a normal state of operation during inspection rounds. Manual evaluation is often based on listening to and touching the machine to detect sounds, noise, vibrations, temperatures etc. indicating an un-balanced behaviour of the machine including the motor.

Hence, manual evaluation may require that the inspection personnel has physical access to the machinery. A number of conditions may complicate or hinder effective manual evaluation:
- non-critical machines may be remotely located at a plant, and hence difficult to access;
- noise generated in a plant with numerous rotational machinery may be at a level and a complexity, which may require a skilled person trained in inspection and evaluation to distinguish the noise generated by one machine from that of a neighbouring machine, and
- plants subjected to restricted access due to hygienic requirements, amongst others.

Unbalanced behaviour may relate to a number of incidents in the machine, which may include misalignments, dry run, torque instability, looseness between parts, wear and tear on bearings, rotor bars, shafts etc.

Another important aspect of achieving an efficient operation of rotational machines is to operate to the machine with correct rotation direction.

Rotating machines are designed to run in a certain direction. For example, a pump or a fan has impeller with "shovels", which can transport much more material e.g. water or air in one rotation direction than in the other.

The rotation direction is set by the motor with the motor running in the forward direction e.g. when three power phases powering the motor is coupled according to instruction. If two phases are reversed the motor runs in reverse direction. This situation may occur at initial installation of the machine or during reinstallation after maintenance, repair etc. Generally it is to be understood that the present disclosure is not limited to neither voltage values and/or number of phases. The sensor device may be used in any suitable rotational machinery.

In other cases, physical circumstances during normal operation may change and force the motor into reverse rotation due to external applied pressure. Such cases could occur in pumps with risers, pumps installed under conditions where the external level of water rises above normal operating conditions, fans exposed to external reverse airstreams etc.

The efficiency of a rotational machine is heavily reduced if it runs in a reverse direction.

Commercial systems for remote condition monitoring of rotational machinery including vibration measurement or vibration analysis are known. Such systems typically comprise sensors collecting data and communicating the data wireless to an external unit e.g. a remote server for performing the data analysis. Handheld and portable devices for vibration diagnostics are also known, and are typically used as a single device for point monitoring of a plurality of machinery during inspection rounds.

A number of handheld measuring devices are known for measuring rotation direction using two-coil-circuits. These devices must be aligned with the shaft directing of the motor and communicate collected data to external devices for further processing and analysis.

### Objective of the disclosure

One objective of this disclosure is to overcome one or more of the before mentioned shortcomings of the prior art.

A further objective is to achieve a sensor device in a single enclosure for continuously condition monitoring.

Yet another objective may be to achieve a sensor device wherein all the analytics and processing are performed on the edge.

Yet another objective may be to achieve a sensor device for easy installation.

The objectives to achieve may furthermore include achieving robust analysis, fast and real time diagnostics and a sensor device signalling easy interpretable indications for the state of the rotational machinery.

An objective may be to achieve a method and device for continuously monitoring of the health condition of rotational machinery.

### Description of the disclosure

Disclosed herein is a sensor device for monitoring rotational machinery when the sensor device is attached thereto.

Rotational machinery includes machines with a motor comprising a rotor and a stator.

The sensor device may comprise an outer enclosure with an outer surface.

The sensor device may further comprise a magnetic field sensor configured for measuring a magnetic field during rotation of the rotor, an accelerometer configured for measuring mechanical vibrations during rotation of the rotor, a data processor arrangement comprising one or more data processors, and one or more signalling units in communication with the data processor arrangement.

The data processor arrangement may be configured to be in communication with the accelerometer for receiving measured vibration signals provided by means of the accelerometer, and to be in communication with the magnetic field sensor for receiving measured magnetic field signals provided by means of the magnetic field sensor.

The data processor arrangement, the accelerometer, the magnetic field sensor and the one or more signalling units may be enclosed by the outer enclosure.

The data processor arrangement may be configured for processing input based on the measured magnetic field signal and the measured vibrational signal according to a predefined set of rules.

The data processor arrangement may be configured to provide an output based on the processing. The output may indicate a machine state selected amongst a plurality of machine states.

The one or more signalling units may be configured for reflecting the selected machine state by means of one or more visual and/or audio signals based on the output provided by the data processor arrangement.

The signalling units may be passive components and may transmit visible signals, audio signals or a combination hereof. The signalling units may include LED diodes, sound generators or comparable components, and may for environmental considerations be low-energy (consuming) elements.

The sensor device may furthermore comprise a data storage. The data storage may be enclosed by the outer enclosure. The data storage may for example be included in the data processor arrangement.

In context of this application, enclosed may refer to that components enclosed by an outer enclosure exist in or are firmly attached within the outer enclosure. E.g. the components may not form part of the outer surface of the outer enclosure. I.e. the enclosed components may be fully cast in their entirety within the outer surface of the outer enclosure. Hence, the enclosed components are comprised completely within or inside the outer enclosure.

One effect of the sensor device may be that it is an embedded device including electronic hardware, mechanical parts and components adapted for performing edge-analytics and -processing. Hence, the sensor device comprises the physical operations of the components that it is enclosed within the sensor unit.

Furthermore, the provided output and hence the signals from the signalling units may be considered concluded outputs, as the output is based on processed and evaluated measurements.

One of the challenges of embedded devices are, that they are subjected to real-time computing constraints i.e. working autonomous (independently of external devices).

Other benefits for the present embedded solution may comprise:
- improved data security
- reduced or limited need of data transmission via public communication network
- cost efficient solution due to reduced or no expenses to external providers of data storage, communication etc.

The sensor device may be used as a condition monitoring sensor for any rotational machinery. This may include dry-installed machines, wet-installed or submerged machines. The embedded nature of the sensor device may facilitate outer enclosures designed to specific uses e.g. different IP-classifications for use in damp or wet conditions or fully submerged or under pressurized conditions; hygienic design for use in the food processing industry, mechanical and chemical resistant for use in various environments.

In one aspect, the outer enclosure may be made of plastic, metal and/or composite materials. The sensor device may be made by casting or moulding the outer enclosure, the sensor device may be coated or foil lined, or may be achieved by similar processes where an outer enclosure with an outer surface is achieved.

Important aspects for the material for the outer enclosure may include the specific material and the thickness of the outer enclosure i.e. the material thickness between the outer surface and the accelerometer and the magnetic field sensor. The outer enclosure should be formed such that mechanical and/or electrical signals can be transmitted, resistant to environmental conditions at the operation position.

One sensor device may be installed or mounted on individual rotational machinery in a plant for continuous monitoring of that specific machinery in the plant. Hence, the intended use of the sensor device may be to mount one sensor on each of the machines subjected for continuously monitoring in a plant.

In one aspect, the physical size of the sensor device when measured on the outer enclosure may be in the region of 3-10cm in two perpendicular directions and thus, spanning in one plane an area of 9-100cm². The height of the sensor device may be in the range of 1-3cm. The stated sizes are merely exemplary sizes and should be considered as such and hence, the sensor device may extend above these sizes or be limited below the stated intervals.

The measurements may be performed continuously using analogue components. The signals to be processed in the data processor arrangement may be received at a given sample rate. The sampling rate may be set according to the application but should comply with normal sampling rate consideration in order to obtain an outcome suitable for further processing e.g. using a sampling frequency such as between 500Hz to 32kHz,

For rotational machinery such as pumps, the rotational speed of the motor may typically be in the range from 0 to 5,000RPM or 0-83.3Hz (83.3Hz = 83.3Hz *60sek/min = 5,000RPM).

The magnetic field sensor may measure the generated magnetic field of the stator and the rotational speed of the motor may be determined based on these measurements.

The accelerometer may measure the rotational frequency of the rotor.

The sensor device may monitor the machinery without any additional input in regard to e.g. intended operation speed. Thus, the sensor device may monitor rotational machinery being regulated through e.g. frequency converters. The sensor device monitors the rotational machinery based on regular and steady operation of e.g. constant rotation speed and periodic vibrations related to the rotational speed.

One advantage of using a mounted sensor on a machine for monitoring is that the measurements over time are comparable. Contrary to handheld or portable devices where the measurements from each inspection round may only be comparable if:
- they are measured with the same sensor as last time;
- the settings of the measuring device are the same as for the previous performed measurements;
- they are performed at the same position, and
- the machine runs at exactly the same speed and/or load as during the last measurement.

The sensor unit may be used for manual inspection with the signalling units giving of a visible signal, an audio signal, or other types of tactile signals including any combination of signals to be easily perceived by the inspection personal during a manual inspection round.

The advantage of signalling units giving off visible indications, e.g. LEDs may be to achieve manual inspecting from a distance without the drawbacks of being exposed to noisy surroundings and to work in difficult accessible areas.

One advantage of the sensor device may be that the signalling units indicates the current state of the rotational machinery. Hence, any operator or inspection personal may achieve real-time process insights, such as system efficiency and current condition of the monitored machinery to:
- Optimize operation
- Plan service actions
- Support manual inspection.
- Use friendly manual inspection of the plant i.e. concluded sensor outputs.

One effect of the sensor device may be that additional parameters may be inferred from the measurements of the magnetic field and the vibrational field. The parameters may include:
- process parameters such as duty cycle, operation time, cavitation, air in media, level of blockage, water hammer, false brinelling, flow turbulence and resonance;
- physical parameters such as temperature, dry-run, vibration, overall vibration level;
- Machine faults such as misalignments, looseness in or between parts and bent shafts, and
- Motor faults such as unbalance, torque instability and wear and tear on bearings, rotor bars, etc.

This list shall be considered as examples and thus, not as an exhaustive list of inferable parameters.

The sensor unit may be designed to be connected and operated to any standard power supply and/or communication network, and thus to be operated using the available power supply and communication network at the premises of the machinery. This may include connection to on-site PLCs, SCADA systems, serial communication connections such as RS485 or comparable communication standards.

In short, the sensor device may be described as:
- Autonomous
- All analytics in sensor
- Real-time
- Robust
- Fieldbus interface

Some of the advantages of the sensor may include:
- Low-priced sensor
- Analytics in the sensor
- Concluded sensor outputs
- Easy integration to other system
- Quick and easy installation

The sensor device may be considered an autonomous condition monitoring sensor for optimizing system health and hence, a useful tool for facilitating increasing system knowledge and health, and improving system utilization and performance.

Due to measuring and processing both the mechanical vibrations and the magnetic field, the signatures in the vibrational field of the machinery and in the magnetic field from the motor may be combined or compared to generate a strong and robust analyse of the state of the machine, and thus a reliable sensor may be achieved.

In one aspect, the sensor device may comprise a signalling unit for indicating if the sensor is powered or not.

In one aspect, the sensor device may comprise additional embedded components for pre-processing of the generated data signals e.g. AD converter, signal processor and/or filter amongst others.

In one aspect, the sensor device may furthermore comprise a communication port for communicating the state of the machinery to an external unit.

In one aspect when using multiple signalling units for indicating the state of the rotation machinery, one signalling unit may be adapted for indicating aspects specifically connected to the magnetic field and hence to the rotation of the motor and another signalling unit may be adapted for indicating aspects specifically connected to the mechanical vibrations of the machinery.

One effect of this embodiment may be that a more specific condition monitoring may be achieved for better troubleshooting and optimized operation. The advantage may be that the concluded sensor outputs indicated by the signalling units may result in an improved evaluation of the state of the machinery and any affected parts. The mechanical vibrations may identify mechanical, motor or operational failures, and the magnetic field may identify electrical or motor failures.

In one aspect, the concluded outputs may be used for trending, i.e. to follow development of faults over time. In other aspects, the concluded outputs may indicate warning and alarm indication to be used for work planning and service prioritization.

In one aspect, the sensor device may comprise a temperature detector, for improved condition monitoring of the machinery. The sensor device may comprise a transducer for indicating a temperature state of the machinery.

In one embodiment, the sensor device may be configured with a mounting area arranged on the outer surface. The mounting area may be adapted for being attachable onto a non-modified surface of the rotational machinery.

Attached or mounted may be used interchangeably in this context.

Non-modified may refer to a non-altered or an intact surface of the rotational machinery. Hence, the sensor device may be mounted or attached without modifying the surface of the machinery by bores, holes, or by melting or welding the surface material of the machinery.

In one aspect the sensor device may be attached or mounted using an adhesive or glue. Alternatively, the sensor may be attached using permanent magnets, mounting brackets or comparable elements.

In one aspect, the adhesive may be two component adhesive, a UV-curable adhesive or any comparable adhesive.

One further effect of this embodiment may be to achieve a stick-on installation for easy mounting. The benefits may include that no modifications of the rotational machinery is required for mounting the sensor. The sensor device may advantageously be mounted without interrupting the operation of the machinery.

Furthermore, a non-skilled person in rotational machinery and installation hereof may mount the sensor onto the machinery.

In one embodiment of the sensor device, the mounting area may comprise a corrugated surface configured to enlarging the surface area of the mounting area.

One further effect of this embodiment may be to achieve an enlarge surface for transferring in particular the mechanical vibrations from the machinery to the sensor. This may be beneficial for improved signal strength with resulting improved analytics.

The enlarged corrugated surface may in particular be beneficial, when attaching the sensor device to the surface using an adhesive or glue.

In a further objective, a method of monitoring rotational machinery using a sensor device attached thereto is disclosed.

Rotational machinery includes machines with a motor comprising a rotor and a stator.

The method comprises acts of measuring a magnetic field with a magnetic field sensor and measuring mechanical vibrations with an accelerometer. The measurements may be performed during rotation of the rotor.

The method may comprise the further acts of receiving measured magnetic field signals and measured vibration signals in a data processor arrangement. Further hereto, the method may comprise acts of selecting a machine state amongst a plurality of machine states based on the received measured magnetic field signal and the received measured vibrational signal according to a predefined set of rules.

The method may comprise an act of providing an output from the data processor arrangement. The output may indicate the selected machine state.

The method may furthermore comprise acts of receiving in one or more signalling units the output provided by the data processor arrangement, and indicating the selected machine state by means of one or more visual and/or audio signals based on the output using one or more of the one or more signalling units.

The provided output and hence the signals from the signalling units may be considered concluded outputs, as the output is based on processed and evaluated measurements.

The intended use of the sensor device may be to mount one sensor on one machine subjected for continuously monitoring in a plant and hence, the concluded output is for that specific machine.

The measurements may be performed as continuous measurements performed at set time intervals. The time intervals may be adjusted according to the operation mode of the rotational machinery, the current condition of the machinery and the importance of operation, amongst others.

Generally, the continuous monitoring may be provided consecutively either with a time interval or when the previous calculation(s) have been completed. Hence, the measurements and the resulting calculations are provided a plurality of times during operation of the rotational machinery in order to provide a sufficient monitoring of the rotational machinery.

The method may generally achieve the effects and advantages previously described for the embodiments of the disclosed sensor device. Similar effects and advantage will therefore only, if at all, be discussed in a brief manner for the following embodiments of the method.

One effect of the method may be that the acts are performing as edge-computing. Hence, the acts may be performed as physical operations of components adapted hereto and the method may correspondingly be considered an embedded method.

Embedded refer in this context to the general conception of embedded software and that the components may be adapted for performing one or more acts of the method without the need of external components e.g. external processing components and/or other active components etc..

The predefined rules may have the effect of monitoring the machinery without any additional input e.g. intended operation speed amongst others.

The method may be used for monitoring any rotating machinery include dry-installed machines, wet-installed, and submerged machines amongst others.

Additional effects of the method may include that additional machinery parameters may be inferred from the measurements of the magnetic field and the vibrational field. Such parameters may amongst others include:
- process parameters such as duty cycle, operation time, cavitation, air in media, level of blockage, water hammer, false brinelling, flow turbulence and resonance;
- physical parameters such as temperature, dry-run, vibration, overall vibration level;
- Machine faults such as misalignments, looseness in or between parts and bent shafts, and
- Motor faults such as unbalance, torque instability and wear and tear on bearings, rotor bars.
This list shall is merely to be considered as examples and thus, not as an exhaustive list of inferable parameters.

In short, the method may be:
- Autonomous,
- Embeddable in a sensor device, e.g. in a sensor device being a single unit or a sensor device comprising multiple connected components arranged on separate locations on the rotational machinery,
- Real-time,
- Robust.

Some of the advantages of a sensor operated with this method may include:
- Embedded analytics in the sensor device,
- Concluded outputs from the sensor device,
- Easy integration of the sensor device with other systems.

A further effect of the method may be, that the signatures in the vibrational field and in the magnetic field may be combined or compared to generate strong and robust analysis.

In one aspect, the output signal(s) may comprise scalar value(s) for indicating a level of the machine state.

In one aspect, the method may include acts of pre-processing the measured or generated data signals in the method.

In one aspect, the method may include an act of communicating the machine state to an external unit.

In one aspect, the concluded outputs may be used for trending, i.e. to follow development of faults over time. In other aspects, the concluded outputs may indicate warning and alarm indication to be used for work planning and service prioritization.

In one aspect, the method may comprise an act of measuring a temperature and provide a temperature state for improved condition monitoring of the machinery. This act may be performed using a temperature dependent material and means for indicating a temperature difference or a measured temperature.

In one aspect when using multiple signalling units for indicating the state of the rotation machinery, one signalling unit may be adapted for indicating aspects specifically connected to the magnetic field and hence to the rotation of the motor and another signalling unit may be adapted for indicating aspects specifically connected to the mechanical vibrations of the machinery.

One effect of this embodiment may be, that a more specific condition monitoring may be achieved for better trouble shutting and optimized operation. One advantage may be, that the concluded sensor outputs indicated by the signalling units may result in an improved evaluation of the state of the machinery and any affected parts. The mechanical vibrations may for example identify mechanical, motor or operational failures, and the magnetic field may for example identify electrical failures or motor failures.

In one aspect, the concluded outputs may be used for trending, i.e. to follow development of faults over time. In other aspects, the concluded outputs may indicate warning and alarm indication to be used for work planning and service prioritization.

In one embodiment of the method of monitoring rotational machinery, the predefined set of rules may comprise finding a global peak point for a received measured signal within a set rotational speed range.

The global peak point may be found by:
- transforming the measured signal from time domain to frequency domain by Fourier transformation, and
- in the frequency domain and within the pre-set rotational speed range, determining a global peak point being a point with a magnitude greater than the magnitude of any other points within the pre-set rotational speed range.

The received measured signals may be the received measured magnetic field signals and/or the received measured vibrational signals, respectively.

In a further embodiment of the method of monitoring rotational machinery, the predefined set of rules may comprises determining a peak frequency, F_{PEAK} of the global peak point.

In one aspect, the peak frequency, F_{PEAK} of a global peak point may be determined as a calculated point using second order interpolation, increasing the RPM resolution.

One effect of this embodiment may be to simplify the analysis of the measured signals. In the frequency domain, any periodic signatures appear as peaks in the Fourier spectrum. Performing the analysis in the frequency domain may reduce the analysis complexity and thus, the required processing and analysis with the advantage of reduced processor power required for performing the analytics. Reducing the required processor power is a general priority in embedded devices using edge-processing.

Rotational machinery operates in a continuously and periodic manner. Hence, the magnetic field and vibrations generated in such rotational machinery are periodic. In addition, any faults, unbalance or operation of the machinery related to the periodic operation of the machinery may also be periodic. The principle of the method is to base the monitoring on signatures generated in the FFT spectrum of the measured signals. The signatures in the FFT spectrum may be supplemented with time wave information. Signatures from the rotational machinery (e.g. pump and motor) may be periodic and appear as a 1X peak, harmonics and side bands. Whereas signatures in a process, e.g. cavitation and water hammer are generally not periodic.

Vibration may be any oscillatory motion caused by a restorative force. One main vibrational frequency is directly caused by the rotating shaft of the rotational machinery and is typically referred to as the fundamental shaft speed or running speed. This vibrational frequency is typically denoted "1X" in the FFT spectrum. A number of Nth order harmonics for the 1X-peak may appear in the FFT spectrum typically referred to as 2X-peak, 3X-peak, ...., 10X-peak etc. The Nth order harmonics may also be used for indication of the health or condition of the machinery.

One important aspects of monitoring rotational machinery may be to monitor a periodic operation of the machinery by detecting a stable position of the global peak frequency i.e. of the 1X peak to ensure a steady operation of the machinery.

In a further embodiment of the method of monitoring rotational machinery, the rotational speed range for one or more received measured vibrational signals may be set based on at least one determined peak frequency, F_{PEAK} of a global peak point of a received measured magnetic signal. The received measured vibrational signal(s) and the received measured magnetic signal are based on a measured magnetic field and measured mechanical vibration(s) within a set time period. The rotational speed range for the one or more received measured vibrational signals may be set as a range between the magnetic field F_{PEAK} and the magnetic field F_{PEAK} minus a set frequency slip.

The time period may be set in accordance with the operation of the rotational machinery, the sampling of the measurements, time intervals between the various received measured signals, in accordance with completion of previous calculation(s) amongst others. The time period should be set such that the rotational speed range for a received measured vibrational signal to be analysed are coupled to a relevant received measured magnetic field signal qua the peak frequency, F_{PEAK}.

One further effect of this embodiment may be to simplify the analysis of the measured signals. In the frequency domain, any periodic signatures appears as peaks in the Fourier spectrum. Performing the analysis in the frequency domain may reduce the analysis complexity and thus, the required processing and analysis with the advantage of reduced processor power required for performing the analytics. Reducing the required processor power is a general priority in embedded devices using edge-processing.

One further effect of this embodiment may be to simplify the analysis of the measured signals. By reducing the window in the Fourier spectrum to be analysed may reduce the complexity of the spectrum and the required processing and analysis with the advantage of reduced processor power required for performing the analytics. Reducing the required processor power is a general priority in embedded devices using edge-processing.

One further effect of this embodiment is to improve the robustness of method. The vibrational frequencies generated due to the motor operation or parts driven by the motor will in general have a lower frequency than the stator rotation due to slip in the motor. This combination or dependency of signatures in the vibrational field and in the magnetic field may be used advantageously for generating strong and robust analysis.

In one aspect, the frequency slip may be set within the range of 0.5 - 1 Hz, e.g. 0.7Hz or 0.8Hz. Hence, the rotational speed range is set to 60RPM - 30RPM (rounds per minute). Setting a window for searching for a vibrational global peak, which window is coupled to the rotational speed or frequency of the global peak of the magnetic field, may ensure that only mechanical vibrations from the monitored rotational machinery is considered. Hence, this window may acts as a filter for any external mechanical vibrations and thus achieving a robust and valid monitoring method.

In a further embodiment of the method of monitoring rotational machinery, the predefined set of rules may comprise determining a peak amplitude, A_{PEAK} of the global peak point.

In one embodiment of the method of monitoring rotational machinery, the predefined set of rules comprises determining a validity of the received measured signals based on the peak amplitude, A_{PEAK} of the global peak point being above a set threshold amplitude level.

In one aspect the threshold value may be set based on previous measurements e.g. as a percentage of a maximum determined peak amplitude.

One further effect of this embodiment is to improve the robustness of method. Setting the machine state based on a minimum amplitude level may ensure that only significant signatures are considered.

Validating received measured signals based on the peak amplitude, A_{PEAK} of the global peak point being above a threshold amplitude level may be especially relevant for monitoring a rotational machinery working with different loads and/or where the motor is operated using frequency drive (frequency converter). I.e. for operation wherein the frequency peak of the global peak point may change during operation and wherein the rotational machinery still operates in a steady and optimal manner. Thus, by simply analysing the received signal for peaks within a given analysis window, the validity of a peak may be confirmed by the amplitude level.

In one embodiment of the method of monitoring rotational machinery, the predefined set of rules may comprise an initial condition of validating a steady operation of the rotational machinery using a number of received measured magnetic field signals and of received measured vibrational signals, wherein the operation of the rotational machinery is set to steady if:
- the determined peak frequency, F_{PEAK} of the global peak point for each of the received measured magnetic field signals are within an allowed frequency deviation;
- the determined peak frequency, F_{PEAK} of the global peak point for each of the received measured vibrational signals are within an allowed frequency deviation;
- the determined peak frequency, F_{PEAK} of the global peak point for each of the received measured vibrational signals are within an allowed frequency slip of one or more of the determined peak frequencies, F_{PEAK} of the global peak point for each of the received measured magnetic field signals.

During the initial condition, the peak amplitude levels A_{PEAK} for the global peak points may be determined for the received measured signals. Hence, the initial condition may furthermore comprise setting a threshold amplitude level and/or validating the global peaks based on the peak amplitude, A_{PEAK} of the global peak point being above a set threshold amplitude level.

In one embodiment of the method of monitoring rotational machinery, the frequency deviation may be 2/60 Hz or preferably 1/60 Hz.

The deviation in the rotational speed of the magnetic field or of the mechanical vibrations for the number of respectively received measured magnetic field signal and received measured vibrational signals may be set to a range of 4 RPM or 2 RPM (rounds per minute) and hence, all the received measured magnetic field signal comprised in the number of received magnetic field signals should comprise a global peak with the peak frequency, F_{PEAK} being within this range, I.e. the deviation between the lowest and the highest magnetic field peak frequency, F_{PEAK} should be within this range.

One effect of this embodiment may be to ensure that the rotational machinery is operating in a steady manner as an initial step in defining the machine baseline for monitoring the machinery.

In one aspect, the frequency slip may be set within the range of 0.5 - 1Hz, e.g. 0.7Hz or 0.8Hz. In one aspect of the method, the actual machine rotational speed is determined during normal operation, with or without use of a frequency drive.

By ensuring an initial steady operation of the machinery, the subsequent continuous monitoring of the machinery may be performed by simply monitoring the validity of the received measured signals based on the peak amplitude, A_{PEAK} being above a threshold amplitude level.

The threshold value may be set as a percentage of a maximum determined peak amplitude found in the initial condition step. As an example, a maximum peak amplitude may be found from the number of received measured magnetic field signals and the threshold value for the peak amplitude of the global peaks in the received measured magnetic field signals may be set to 60% of the maximum determined peak amplitude, alternatively to 70% or 80%.

The threshold value for the peak amplitude of the global peaks in the received measured vibrational signals may likewise be set to e.g. 60%, 70% or 80% of a maximum determined peak amplitude found from the number of received measured vibrational signals and the threshold value for the peak amplitude of the global peaks in the received measured vibrational signals.

This secure high validity of the determined rotational machine speed, reducing the impact of neighbour machineries.

This may reduce the computational requirements of the data processor arrangement and any data storage.

Furthermore, the rotational machinery may be monitored without requiring any additional information of load or speed regulation feed to the method.

In one further embodiment of the method of monitoring rotational machinery, the act of indicating the selected machine state may include using at least one signalling unit for indicating the validity of the received measured magnetic field signals and using at least one signalling unit for indicating the validity of the received measured vibrational signal.

The indication of the validity of the different measurements may be beneficial in diagnosing the machinery in case of a reported machine state indicating a fault.

In a further embodiment of the method of monitoring rotational machinery, the machine state is set to one of at least two values: non-determined or positive.

The value may default be set to non-determined.

The value may be set to positive when a steady operation of the rotational machinery has been validated

In a further aspect, once a steady operation of the machinery has been validated, the continued monitoring of the rotational machinery and hence the continued evaluation of the machine state may be based on the subsequent received measured signals and the validity hereof based on the peak amplitude, A_{PEAK} of the global peak point being above a set threshold amplitude level.

The machine state may be set to positive if the received measured signals are considered valid due to the peak amplitude, A_{PEAK} of the global peak point being above the set threshold amplitude level.

The value of the machine state may be set to non-determined otherwise.

In one embodiment of the method, the monitoring of the rotational machinery may comprise using the disclosed sensor device for monitoring rotational machinery.

The method may generally achieve the effects and advantages previously described for the embodiments of the disclosed sensor device and the effects and advantages of the method of monitoring rotational machinery. The effects and advantage will therefore not be recited here

In a further objective the method of monitoring rotational machinery may comprise additional acts of locating a valid mounting position of the sensor device based on the indicated selected machine state by means of the one or more visual and/or audio signals from the one or more signalling units, and mounting the sensor unit on the surface of the rotational machinery in the located valid mounting position.

One effect of this embodiment may be to achieve a sensor device for easy installation. The concluded output can be used for guided location of a valid mounting point. A valid mounting point is a position of the sensor device where a sufficient strong and thus positive signal may be measured.

In this case the indicated validity of the different measured signals may act as a guide for location of a valid mounting position. The mounting position do not need to be the optimal position but simply a position where sufficient reliable measurements are achieved.

The valid mounting position may be given by a location, where the signalling units indicates each of the signal as being valid.

The benefits may support the aim of an easy mountable sensor unit for correct mounting resulting in a robust and reliable monitoring of the machinery.

It should be noted that the machinery should preferably be operated in a correct and optimal manner when locating the mounting position.

The edge-computing, the embedded character of the sensor device and the concluded output in combination achieves this additional use or dual-use of the sensor device as a 'self-guiding' sensor device during installation and a sensor device for continuous monitoring of the rotational device once mounted onto the surface hereof.

In a further embodiment of the method, the sensor device may be mounted on the surface of the machinery in the valid mounting position using an adhesive arranged between the surface of the mounting area of the sensor device and the surface of the rotational machinery.

In one aspect, the adhesive may be two component adhesive, a UV-curable adhesive or any comparable adhesive.

One further effect of this embodiment may be to achieve an easy stick-on mounting. The benefits may include that no modifications of the rotational machinery is required for mounting the sensor. Furthermore, a non-skilled person in rotational machinery and installation hereof may mount the sensor onto the machinery surface

The adhesive may furthermore establish a good mechanical contact between the sensor device and the rotational machinery for improved transmittance of especially thermal and vibrational fields.

In a further objective, a rotational machinery having a surface and a motor comprising a rotor and a stator is disclosed. The machinery comprises the sensor device attached to the surface and adapted to perform the method of monitoring rotational machinery.

In a further objective, a computer program is disclosed. The computer program comprises instructions to cause the disclosed sensor device to execute the steps of any one or more of the methods of monitoring rotational machinery and/or the method of mounting the sensor device.

In a further objective, an embedded computer-readable medium is disclosed. The computer-readable medium having stored there on the disclosed computer program.

Disclosed herein is an alternative sensor device for monitoring rotational machinery when the sensor device is attached thereto. Also disclosed is a method or monitoring rotational machinery using this alternative sensor device.

The alternative sensor device may be combined with the embodiments previously described for the sensor device either in full or partly. The method may likewise include acts of the methods previously disclosed for the sensor device. The method acts may depend on the components and their adapted functionality and thus the specific embodiments of the methods should be read in accordance with a sensor device embodiment supporting the acts.

In the following the references to alternative sensor device and alternative method of monitoring will be used in order to clarify which embodiments of the sensor device and methods are discussed.

The alternative sensor device and the alternative method may generally achieve the effects and advantages previously described for the embodiments of the previously disclosed sensor device and methods using this sensor when incorporating identical parts or acts from the previous embodiments in the alternative embodiments.

Similar effects and advantage will therefore be discussed in a more briefly manner for each of embodiments of both the alternative method and the alternative sensor unit.

Disclosed herein is an alternative sensor device for monitoring rotational machinery when the sensor device is attached thereto.

Rotational machinery includes machines with a motor comprising a rotor and a stator.

The alternative sensor device may comprise an outer enclosure with an outer surface.

The alternative sensor device may further comprise a measuring circuit comprising a first sensor element and a second sensor element configured to measure a field during rotation of the rotor, a data processor arrangement comprising one or more data processors, and one or more signalling units in communication with the data processor arrangement.

The data processor arrangement may be configured to be in communication with the measuring circuit for receiving measured first field signals provided by means of the first sensor element and measured second field signals provided by means of the second sensor element.

The data processor arrangement, the measuring circuit and the one or more signalling units may be enclosed by the outer enclosure. The data processor arrangement may be configured for processing input based on the measured first and second field signals according to a predefined set of rules.

The data processor arrangement may be configured to provide an output based on the processing. The output may indicating a machine state selected amongst a plurality of machine states.

The one or more signalling units may be configured for reflecting the selected machine state by means of one or more visual and/or audio signals based on the output provided by the data processor arrangement.

The first sensor element and the second sensor element may be adapted to measure on the same field type and may be arranged in mirror symmetry about a first axis and a second axis being perpendicular to the first axis.

The first sensor element and the second sensor element are adapted to measure on the same type of field.

The alternative sensor device may furthermore comprise a data storage. The data storage may be enclosed by the outer enclosure. The data storage may for example be included in the data processor arrangement.

The effect of the alternative sensor device is to measure the same generated field with two sensor elements physically displaced. The generated field can therefore be measured with a time difference or in a time order of a signature or event in the measured field or signal. This time difference may be used for determining the rotational direction of the motor.

The effect of arranging the first sensor element and the second sensor element with mirror symmetry may be the sensor device can be operated in any 90 degrees rotation of the shaft direction of the motor.

The measurements may be performed as continuous measurements performed at set time intervals. The time intervals may be adjusted according to the operation mode of the rotational machinery, the current condition of the machinery and the importance of operation, amongst others.

Generally, the continuous monitoring may be provided consecutively either with a time interval or when the previous calculation(s) have been completed. Hence, the measurements and the resulting calculations are provided a plurality of times during operation of the rotational machinery in order to provide a sufficient monitoring of the rotational machinery.

In one aspect, the type of field may be a magnetic field, a vibrational field or an acoustic field.

Mirror symmetry about the first axis and the second axis, may also be 180 degrees rotational symmetry in the plane comprising the two axis rotated around a centre axis perpendicular to the plane.

Mirror symmetry may be achieved by mirroring the component about the first axis and subsequently mirroring the component about the second axis or in the opposite order.

In one aspect the alternative sensor device may comprise a comparator for determining the time difference. The comparator may be comprised in the data processor arrangement.

In a further aspect, the comparator may be implemented as a hardware component or comprised in a computer program.

Similar to the previous disclosed sensor device may, the alternative sensor device may comprise additional enclosed components for pre-processing of the generated data signals e.g. AD converter, signal processor and/or filter amongst others.

Furthermore, the alternative sensor device may likewise comprise a communication port for communicating the machine state to an external unit.

In one embodiment of the alternative sensor device, the first and second sensor elements both comprises an accelerometer, a coil, a hall element or a microphone.

The choice of sensor elements may depend on the quality of the measurements to be achieved and price. Theses parameters may often point in different directions and a trade-off or balancing of influence of the individual parameters may be made.

Using coils may result in good and robust measurement to be obtained at a distance from the motor. For example, if the sensor is mounted on a pump, it may still be possible to measure the motor's magnetic field with coils.

Hall elements are typically cheap and simple to use. However, the measured signals are generally weaker than when measured with coils. I.e. the sensor device using Hall elements may be arranged closer to the motor for achieving reliable.

Accelerometer may be simple 1-axis accelerometers or more advanced 3-axis accelerometers, where measurements of one or more of the axis for each accelerometer may be compare. However, the subsequent data processing may require more operations than for embodiments using coils or Hall elements. A small time shift in two vibration signals may generally require more processor operations than magnetic field signals.

Microphones represent currently a rather expensive solution. Microphones have the advantage that they require limited space in regard to a printed circuit board (PCB). The use of microphones may be considered a well-confirmed approach, as many manual inspections are performed by listening to the machines for evaluating the machine state.

Audio signals may provide additional information in case the output is recorded or distributed to external units for any remote manual inspection or monitoring.

In one embodiment of the alternative sensor device, the first and second sensor elements are arranged in one plane comprising the first axis and the second axis.

In one aspect, the two sensor devices for monitoring rotational machinery may be integrated into a single sensor device comprising some or all of the embedded components comprised in both sensor devices.

Alternatively, one of the sensor devices for monitoring rotational machinery may comprise embedded elements of the other above-disclosed sensor device including a defined geometry with a first axis and a second axis perpendicular to the first axis.

Hence, the disclosed sensor device referred to above as the alternative sensor device may include the embodiments disclosed here below. The embodiments below may generally have the effects and advantages previously described for the embodiments of the previously disclosed sensor device comprising some or all of the same components. The effects and advantage will therefore be discussed in a more briefly manner for each of the following embodiments.

In one embodiment, the alternative sensor device further comprises
- a magnetic field sensor configured for measuring a magnetic field during rotation of the rotor, and
- an accelerometer configured for measuring mechanical vibrations during rotation of the rotor.

The accelerometer and the magnetic field sensor are enclosed by the outer enclosure.

The data processor arrangement may be further configured to be in communication with the accelerometer for receiving measured vibration signals provided by means of the accelerometer and to be in communication with the magnetic field sensor for receiving measured magnetic field signals provided by means of the magnetic field sensor. Furthermore, the data processor arrangement may be configured for processing input based on the measured magnetic field signal and the measured vibrational signal according to the predefined set of rules.

In one embodiment of the alternative sensor device the magnetic field sensor may be configured as the first sensor element or the second sensor element.

In one embodiment of the alternative sensor device the accelerometer may be configured as the first sensor element or the second sensor element.

One effect may be to use one component for two different measurements, thereby reducing the number of components in the sensor device. This may additionally reduce the complexity and the cost of the sensor device.

In one embodiment, the alternative sensor device may be configured with a mounting area arranged on the outer surface adapted to be attached onto a non-modified surface of the rotational machinery using an adhesive.

Alternatively, a glue, permanent magnets, mounting brackets or comparable elements may be used for mounting or attaching the sensor to the surface.

In one embodiment of the alternative sensor device, the mounting area may comprise a corrugated surface configured for enlarging the surface area of the mounting area.

In a further objective, an alternative method of monitoring rotational machinery using a sensor device attached thereto is disclosed.

The alternative method may comprise acts of measuring a field with the first sensor element and the second sensor element. The measurements may be performed during rotation of the rotor.

The alternative method may comprise the further acts of receiving measured first field signals provided by means of a first sensor element and measured second field signals provided by a second sensor element in a data processor arrangement, and selecting a machine state amongst a plurality of machine states based on the received measured first field signal and the received measured second field signal according to a predefined set of rules.

The alternative method may comprise an act of providing an output from the data processor arrangement. The output may indicate the selected machine state.

The alternative method may furthermore comprise acts of receiving in one or more signalling units the output provided by the data processor arrangement, and indicating the selected machine state by means of one or more visual and/or audio signals based on the output using one or more of the one or more signalling units.

The alternative sensor device may be arranged with a first axis being parallel to a rotational plane of the rotor and a second axis being arranged non-parallel to the rotational plane of the rotor, and the first sensor element and the second sensor element may be arranged in mirror symmetry about the first axis and the second axis being perpendicular to the first axis.

The effect of the alternative method is that one generated field is measured using two sensor elements physically displaced. The generated field can therefore be measured with a time difference or in a time order of a signature or event in the measured field or signal. This time difference may be used for determining the rotational direction of the motor.

The effect of arranging the first sensor element and the second sensor element with mirror symmetry may be the sensor device can be operated in any 90 degrees rotation of the shaft direction of the motor.

Time difference, order of arrival or time-of-flight are general expressions used for determining a rotation direction using two measured signals from the same generated field. I.e. it is determined which signal comes first. E.g. a sine signal is measured with coil 1 and one with coil 2 with a little time offset: if "signal coil 1" comes before "signal coil 2", this may be defined as forward direction; If "signal coil 2" comes before "signal coil 1", this may be defined as reverse direction.

The coils and signals there from may be numbered and communicated according to any standards used for rotational machinery.

The measurements may be performed as continuous measurements performed at set time intervals. The time intervals may be adjusted according to the operation mode of the rotational machinery, the current condition of the machinery and the importance of operation, amongst others.

The provided output and hence the signals from the signalling units may be considered concluded outputs, as the output is based on processed and evaluated measurements. The intended use of the alternative sensor device may be to mount one sensor on each of the machines subjected for continuously monitoring in a plant and hence, the concluded output is for that specific machine.

The measurements may be performed as continuous measurements performed at set time intervals. The time intervals may be adjusted according to the operation mode of the rotational machinery, the current condition of the machinery and the importance of operation, amongst others.

The method may generally achieve the effects and advantages previously described for the embodiments of the disclosed alternative sensor device. The effects and advantage will therefore be discussed in a more briefly manner for each of the following embodiments of the method.

One effect of the method may be that the acts are performing as edge-computing. Hence, the acts may be performed as physical operations of components adapted hereto and the method may correspondingly be considered an embedded method.

Embedded refer in this context to the general conception of embedded software and that the components may be adapted for performing one or more acts of the method without the need of external components e.g. external processing components and/or other active components etc..

The predefined rules may have the effect of monitoring the machinery without any additional input.

The method may be used for monitoring any rotating machinery include dry-installed machines, wet-installed, and submerged machines amongst others.

The disclosed methods of monitoring rotational machinery may comprise one or more of the disclosed acts comprised in one of the other disclosed methods.

Hence, the disclosed method referred to above as an alternative method of monitoring rotational machinery may include the embodiments disclosed here below. The below embodiments may generally have the effects and advantages previously described for the embodiments of the previously disclosed method of monitoring rotational machinery sensor device comprising some or all of the same acts. The effects and advantage will therefore only be discussed briefly, if at all, for each of the following embodiments.

In one embodiment of the alternative method of monitoring rotational machinery, the predefined set of rules includes a determined rotation direction of the motor. The rotation direction may be determined by comparing the time order of reception in the data processor arrangement, of the received measured first field signal and the received measured second field signal.

Alternatively, the time order may be compared in a HW circuit.

The rotation direction may be defined as forward e.g. Clock Wise (CW) and reverse e.g. Counter Clock Wise (CCW). According to DIN standard EN 60034-8, CW and CCW are defined as follows: If you stand behind the engine and look in over the shaft, CW is defined when the engine turns clockwise and CCW when the shaft rotates counter clockwise.

However, opposite definitions are commonly used as well. And the sensor may be configured accordingly in regard to the intended operation of the rotational machinery. Hence the first and second sensor elements may be defined accordingly.

In a further embodiment, the alternative method of monitoring rotational machinery comprises further acts of:
- during rotation of the rotor, measuring a magnetic field with the magnetic field sensor;
- during rotation of the rotor, measuring mechanical vibrations with the accelerometer;
- receiving the measured magnetic field signals and the measured vibration signals in the data processor arrangement;
- selecting a machine state amongst the plurality of machine states further based on the received measured magnetic field signal and the received measured vibrational signal according to the predefined set of rules.

In one aspect when using multiple signalling units for indicating the machine state, one signalling unit may be adapted for indicating aspects specifically connected to the magnetic field and hence to the rotation of the motor, another signalling unit may be adapted for indicating aspects specifically connected to the mechanical vibrations of the machinery and a third signalling unit may be adapted for indicating a rotation direction of the motor.

One effect of this embodiment may be that a more specific condition monitoring may be achieved for better troubleshooting and optimized operation. The advantage may be that the concluded sensor outputs indicated by the signalling units may result in an improved evaluation of the state of the machinery and any affected parts. The mechanical vibrations may identify mechanical, motor or operational failures, and the magnetic field may identify electrical or motor failures.

In one aspect, the concluded outputs may be used for trending, i.e. to follow development of faults over time. In other aspects, the concluded outputs may indicate warning and alarm indication to be used for work planning and service prioritization.

In one embodiment of the alternative method of monitoring rotational machinery, the predefined set of rules may comprise finding a global peak point for a received measured signal within a set rotational speed range.

The global peak point may be found by:
- Transforming the measured signal from time domain to frequency domain by Fourier transformation, and
- in the frequency domain and within the pre-set rotational speed range, determining a global peak point being a point with a magnitude greater than the magnitude of any other points in the pre-set rotational speed range.

The received measured signals may be the received measured magnetic field signals and/or the received measured vibrational signals, respectively.

In a further embodiment of the alternative method of monitoring rotational machinery, the predefined set of rules may comprises determining a peak frequency, F_{PEAK} of the global peak point.

In one aspect, the peak frequency, F_{PEAK} of a global peak point may be determined as a calculated point using second order interpolation, increasing the RPM resolution.

In a further embodiment of the alternative method of monitoring rotational machinery, the predefined set of rules may comprise determining a peak amplitude, A_{PEAK} of the global peak point.

The effects of this embodiment may be according to those previously discussed in connection with this predefined set of rules. These includes:
- simplifying the analysis of the measured signals working in the frequency domain and hence reducing the required processor power which is a general priority in embedded devices using edge-processing;
- supporting the principle of the method based on that rotational machinery operates in a continuously and periodic manner;
- supporting the operation of the sensor for monitoring the machinery without any additional input e.g. in regard to intended operation speed amongst other.

In one aspect of the alternative method of monitoring rotational machinery, the predefined set of rules may include, searching for the peak frequency, F_{PEAK} of the global peak point of a received measured vibrational signal within a rotation speed window being equal to or lower than the peak frequency, F_{PEAK} of the global peak point of a received measured magnetic field signal. The lower value of the window may be based on a set frequency slip.

In one aspect, the frequency slip may be set to any value between 1 Hz and 0.5 Hz e.g. 0.7 Hz or 0.8Hz.

The effects of this aspect may be according to those previously discussed in connection with this predefined set of rules. These includes the above mentioned effects and the additional effects of:
- simplifying the analysis of the measured signals by reducing the window in the Fourier spectrum to be analysed and thus, reducing the required processor power is a general priority in embedded devices using edge-processing;
- improving the reliability of the method by defining a dependency of signatures in the vibrational field with signatures in the magnetic field for generating strong and robust analysis.

In one embodiment of the alternative method of monitoring rotational machinery, the predefined set of rules may comprise an initial condition of validating a steady operation of the rotational machinery using a number of received measured magnetic field signals and of received measured vibrational signals, wherein the operation of the rotational machinery is set to steady if:
- the determined peak frequency, F_{PEAK} of the global peak point for each of the received measured magnetic field signals are within an allowed frequency deviation;
- the determined peak frequency, F_{PEAK} of the global peak point for each of the received measured vibrational signals are within an allowed frequency deviation;
- the determined peak frequency, F_{PEAK} of the global peak point for each of the received measured vibrational signals are within an allowed frequency slip of one or more of the determined peak frequency, F_{PEAK} of the global peak point for each of the received measured magnetic field signals.

During the initial condition the peak amplitude levels, A_{PEAK} for the global peak points may be determined for the received measured signals. Hence, the initial condition may furthermore comprise setting a threshold amplitude level and/or validating the global peaks based on the peak amplitude, A_{PEAK} of the global peak point being above a set threshold amplitude level.

In one embodiment of the method of monitoring rotational machinery, the frequency deviation may be 2/60Hz or preferably 1/60Hz.

The deviation in the rotational speed of the magnetic field or of the mechanical vibrations for the number of respectively received measured magnetic field signal and received measured vibrational signals may be set to a range of 2 RPM or 1 RPM (rounds per minute) and hence, all the received measured magnetic field signal comprised in the number of received magnetic field signals should comprise a global peak with the peak frequency, F_{PEAK} being within this range, I.e. the deviation between the lowest and the highest magnetic field peak frequency, F_{PEAK} should be within this range.

One effect of this embodiment may be to ensure that the rotational machinery is operating in a steady manner as an initial step in defining the machine baseline for monitoring the machinery.

In one aspect, the frequency slip may be set within the range of 0.5 - 1Hz, e.g. 0.7Hz or 0.8Hz. In one aspect of the method, the actual machine rotational speed is determined during normal operation, with or without use of a frequency drive.

By ensuring an initial steady operation of the machinery, the subsequent continuous monitoring of the machinery may be performed by simply monitoring the validity of the received measured signals based on the peak amplitude, A_{PEAK} being above a threshold amplitude level.

The threshold value may be set as a percentage of a maximum determined peak amplitude found in the initial condition step. As an example, a maximum peak amplitude may be found from the number of received measured magnetic field signals and the threshold value for the peak amplitude of the global peaks in the received measured magnetic field signals may be set to 60% of the maximum determined peak amplitude, alternatively to 70% or 80%.

The threshold value for the peak amplitude of the global peaks in the received measured vibrational signals may likewise be set to e.g. 60%, 70% or 80% of a maximum determined peak amplitude found from the number of received measured vibrational signals and the threshold value for the peak amplitude of the global peaks in the received measured vibrational signals.

This embodiment may secure a high validity of the determined rotational machine speed, reducing the impact of neighbour machineries.

This embodiment may reduce the computational requirements of the data processor arrangement and any data storage.

Furthermore, the rotational machinery may be monitored without requiring any additional information of load or speed regulation feed to the method.

In one embodiment of the alternative method of monitoring rotational machinery, the act of indicating the selected machine state may include using at least one signalling unit for indicating a rotational direction of the motor. Furthermore, the method may comprise that the machine state is set to one of at least two values comprising non-determined or positive, wherein the value is set to:
- positive when a steady operation of the rotational machinery has been validated, and
- non-determined otherwise.

One effect of this embodiment may be, that a more specific condition monitoring may be achieved for better trouble shutting and optimized operation. One advantage may be, that the concluded sensor outputs indicated by the signalling units may result in an improved evaluation of the state of the machinery and any affected parts. The indication of the rotational direction of the motor may be beneficial in diagnosing the machinery in case of a reported machine state indicating a fault. A machinery rotating in a reverse direction may not be detected by monitoring the mechanical vibrations and/or the magnetic field. The rotational machinery may operate in a reliable and periodic manner. However, the efficiency when operating the machinery in reverse direction is generally decreased significantly, and hence monitoring of the rotational direction may be beneficial for achieving optimal operation.

In a further aspect, once a steady operation of the machinery has been validated, the continued monitoring of the rotational machinery and hence the continued evaluation of the machine state may be based on the subsequent received measured signals and the validity hereof based on the peak amplitude, A_{PEAK} of the global peak point being above a set threshold amplitude level.

The machine state may be set to positive if the received measured signals are considered valid due to the peak amplitude, A_{PEAK} of the global peak point being above the set threshold amplitude level.

The value of the machine state may be set to non-determined otherwise.

In one embodiment of the method, the monitoring of the rotational machinery may comprise using the disclosed sensor device for monitoring rotational machinery.

The method may generally achieve the effects and advantages previously described for the embodiments of the disclosed sensor device and the effects and advantages of the method of monitoring rotational machinery. The effects and advantage will therefore not be recited here

In general, the disclosed methods of monitoring rotational machinery may be integrated into a single method comprising some or all of the acts comprised in the methods. The method may be performed using a corresponding sensor device comprising the enclosed components adapted for performing the acts.

In one embodiment of the alternative method of monitoring rotational machinery, the monitoring of the rotational machinery may comprise using the disclosed alternative sensor device for monitoring rotational machinery.

The method may generally achieve the effects and advantages previously described for the embodiments of the disclosed sensor device and the effects and advantages of the method of monitoring rotational machinery. The effects and advantage will therefore not be recited here

In one embodiment of the alternative method, the act of indicating the selected machine state may include using at least one signalling unit for indicating a rotation direction of the motor.

In a further objective, a rotational machinery having a surface and a motor comprising a rotor and a stator is disclosed. The machinery comprises the sensor device attached to the surface and adapted to at least perform the alternative method of monitoring rotational machinery.

In a further objective, a computer program is disclosed. The computer program may comprise instructions to cause the disclosed sensor device to execute the steps of any one or more of the methods of monitoring rotational machinery and/or the method of mounting the sensor device.

The sensor device may be any one of the disclosed embodiments of the sensor device including the first disclosed sensor device and the sensor device referred to as the alternative sensor device.

In a further objective, an embedded computer-readable medium is disclosed. The computer-readable medium having stored there on the above disclosed computer program.

### Brief description of the drawings

Various examples are described hereinafter with reference to the figures. Like reference numerals refer to like elements throughout. Like elements will, thus, not be described in detail with respect to the description of each figure. It should also be noted that the figures are only intended to facilitate the description of the examples. They are not intended as an exhaustive description of the claimed invention or as a limitation on the scope of the claimed invention. In addition, an illustrated example needs not have all the aspects or advantages shown. An aspect or an advantage described in conjunction with a particular example is not necessarily limited to that example and can be practiced in any other examples even if not so illustrated, or if not so explicitly described.
Figure 1 illustrates two embodiments of the sensor device for magnetic field and/or vibrational field monitoring.
Figure 2 illustrates two embodiments of the alternative sensor device configured for rotation direction monitoring.
Figure 3 illustrates two embodiments of the alternative sensor device with a reduced number of components.
Figure 4 illustrates three embodiments of the sensor device.
Figure 5 illustrates one embodiment of the method of monitoring rotational machinery.
Figure 6 illustrates two embodiments of the predefined set of rules comprised in the method of monitoring rotational machinery.
Figure 7 illustrates exemplary examples of measured and analysed signals.
Figure 8 illustrates one embodiment of the alternative method of monitoring rotational machinery.

### Detailed description of the disclosure

| No | Item |
|---|---|
| 1 | rotational machinery |
| 2 | motor |
| 4 | surface (rotational machinery) |
| 10 | sensor device |
| 12 | outer enclosure |
| 14 | outer surface |
| 16 | mounting area |
| 18 | first axis |
| 19 | second axis |
| 20 | magnetic field sensor |
| 30 | accelerometer |
| 40 | data processor arrangement |
| 42 | data processors |
| 44 | data storage |
| 50 | signalling units |
| 60 | adhesive |
| 70 | rotational speed range |
| 76 | number of signals to be measured |
| 78 | frequency deviation |
| 80 | global peak point |
| 82 | peak frequency, F_{PEAK} |
| 84 | peak amplitude, A_{PEAK} |
| 90 | threshold amplitude level |
| 92 | frequency slip |
| 120 | measuring circuit |
| 130 | first sensor element |
| 140 | second sensor element |
| 150 | comparator |
| 200 | magnetic field |
| 202 | measured magnetic field signal |
| 300 | mechanical vibrations |
| 302 | measured vibration signal |
| 430 | field |
| 432 | first field signal |
| 442 | second field signal |
| 500 | output |
| 510 | machine state |
| 520 | validity |
| 700 | method (monitoring) |
| 702 | measuring |
| 704 | receiving |
| 706 | determining |
| 708 | providing |
| 709 | indicating |
| 712 | transforming |
| 714 | selecting |
| 750 | set of rules |
| 900 | computer program |
| 910 | computer-readable medium |

Exemplary embodiments will now be described more fully hereinafter with reference to the accompanying drawings. In this regard, the present examples may have different forms and should not be construed as being limited to the descriptions set forth herein. Accordingly, the examples are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

In the drawings, thicknesses of a plurality of layers and areas are illustrated in an enlarged manner for clarity and ease of description thereof. When a layer, area, element, or plate is referred to as being "on" another layer, area, element, or plate, it may be directly on the other layer, area, element, or plate, or intervening layers, areas, elements, or plates may be present there between. Conversely, when a layer, area, element, or plate is referred to as being "directly on" another layer, area, element, or plate, there are no intervening layers, areas, elements, or plates there between. Further when a layer, area, element, or plate is referred to as being "below" another layer, area, element, or plate, it may be directly below the other layer, area, element, or plate, or intervening layers, areas, elements, or plates may be present there between. Conversely, when a layer, area, element, or plate is referred to as being "directly below" another layer, area, element, or plate, there are no intervening layers, areas, elements, or plates there between.

The spatially relative terms "lower" or "bottom" and "upper" or "top", "below", "beneath", "less", "above", and the like, may be used herein for ease of description to describe the relationship between one element or component and another element or component as illustrated in the drawings. It will be understood that the spatially relative terms are intended to encompass different orientations of the device in use or operation, in addition to the orientation depicted in the drawings. For example, in the case where a device illustrated in the drawings is turned over, elements described as being on the "lower" side of other elements, or "below" or "beneath" another element would then be oriented on "upper" sides of the other elements, or "above" another element. Accordingly, the illustrative term "below" or "beneath" may include both the "lower" and "upper" orientation positions, depending on the particular orientation of the figure. Similarly, if the device in one of the figures is turned over, elements described as "below" or "beneath" other elements would then be oriented "above" the other elements. The exemplary terms "below" or "beneath" can, therefore, encompass both an orientation of above and below, and thus the spatially relative terms may be interpreted differently depending on the orientations described.

Throughout the specification, when an element is referred to as being "connected" to another element, the element is "directly connected" to the other element, or "electrically connected" to the other element with one or more intervening elements interposed there between.

The terminology used herein is for the purpose of describing particular examples only and is not intended to be limiting. As used herein, the singular forms "a," "an," and "the" are intended to include the plural forms, including "at least one," unless the content clearly indicates otherwise. "At least one" is not to be construed as limiting "a" or "an." It will be further understood that the terms "comprises," "comprising," "includes" and/or "including," when used in this specification, specify the presence of stated features, integers, steps, operations, elements, and/or components, but do not preclude the presence or addition of one or more other features, integers, steps, operations, elements, components, and/or groups thereof.

It will be understood that, although the terms "first," "second," "third," and the like may be used herein to describe various elements, these elements should not be limited by these terms. These terms are only used to distinguish one element from another element. Thus, "a first element" discussed below could be termed "a second element" or "a third element," and "a second element" and "a third element" may be termed likewise without departing from the teachings herein.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Unless otherwise defined, all terms used herein (including technical and scientific terms) have the same meaning as commonly understood by those skilled in the art to which this invention pertains. It will be further understood that terms, such as those defined in commonly used dictionaries, should be interpreted as having a meaning that is consistent with their meaning in the context of the relevant art and will not be interpreted in an idealized or overly formal sense unless expressly so defined in the present specification.

Exemplary examples are described herein with reference to cross section illustrations that are schematic illustrations of idealized examples, wherein like reference numerals refer to like elements throughout the specification. As such, variations from the shapes of the illustrations as a result, for example, of manufacturing techniques and/or tolerances, are to be expected. Thus, examples described herein should not be construed as limited to the particular shapes of regions as illustrated herein but are to include deviations in shapes that result, for example, from manufacturing. For example, a region illustrated or described as flat may have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims. Some of the parts which are not associated with the description may not be provided in order to specifically describe exemplary examples of the present disclosure.

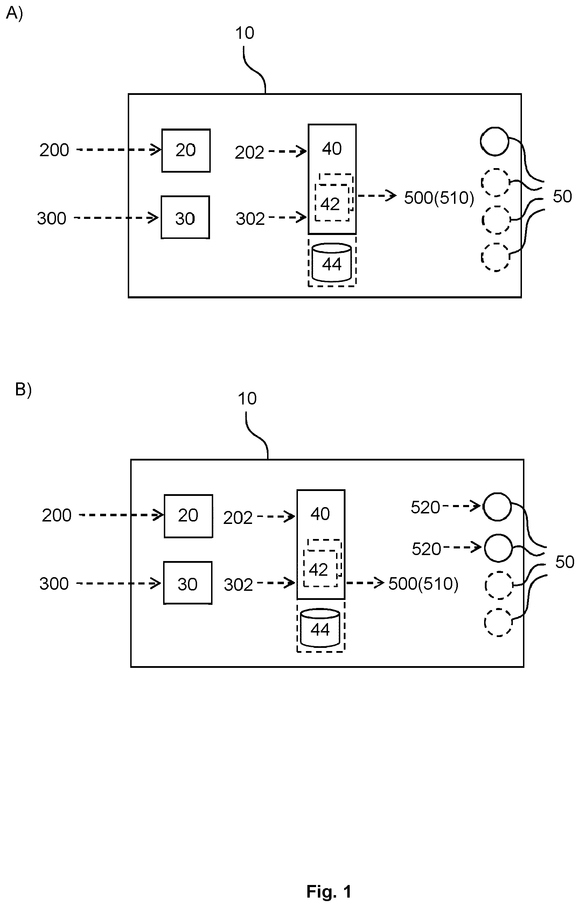

Figure 1 illustrates two embodiments of the sensor device 10 for monitoring rotational machinery having a motor.

Figure 1A illustrates one embodiment of the sensor device 10 comprising an embedded magnetic field sensor 20 and an embedded accelerometer 30.

The magnetic field sensor is configured for measuring a magnetic field 200. The field may be continuously measured with set time intervals.

The accelerometer is configured for measuring mechanical vibrations 300. The vibrations may be continuously measured with set time intervals.

The illustrated sensor device 10 furthermore comprises a data processor arrangement 40 comprising one or more data processors 42 and a data storage 44. The one or more data processors are illustrated by the dashed boxes.

The data processor arrangement 40 receives measured vibration signals 302 and measured magnetic field signals 202. The received signals are based on the measurements performed by the accelerometer 30 and the magnetic field sensor 20, respectively.

The data processor arrangement 40 is configured for processing input based on the measured magnetic field signal 202 and the measured vibrational signal 302 according to a predefined set of rules.

The data processor arrangement 40 provides an output 500 based on the processing. The output 500 indicates a machine state 510 selected amongst a plurality of machine states,

The data storage 44 may be used as a FIFO buffer for storing the peak frequency, F_{PEAK} and the peak amplitude, A_{PEAK} for one or more of the received measured signals.

The data storage may further more comprise data related to the predefined rules and the machines states, threshold values, allowed frequency deviation, frequency slip amongst others.

The sensor device 10 furthermore comprise one or more signalling units 50. The dashed circles illustrate the implementation of multiple signalling units 50.

The signalling units 50 are in communication with the data processor arrangement 40. The signalling units 50 are adapted for indicating the machine state comprised in the output signal 500.

Figure 1B illustrates another embodiment of the sensor device 10. Wherein the signalling units are adapted for indicating a validity 520 of the measured fields or signals

The signalling units 50 are adapted for indicating the machine state 510 comprised in the output signal 500. The signalling units are furthermore be adapted for indicating a validity 520 of the measured field.

The validity 520 and/or the machine state 510 may for example be set as positive or non-determined. Alternatively as positive, negative and non-determined e.g. the motor direction may be indicated by the values as counter clock-wise, clock-wise or non-operational. In these case, a LED as signalling unit may indicate the states by simply green and off, green, red and off or green and red with red indicating both a negative and a non-determined value. Alternatively, the state may be set to a scalar value and indicated by use of an LED but using a broader range of colours or flashing operating of the LED. In yet another alternative embodiment, the transducers may give off acoustic signals or a combination of visible and acoustic signals for indicating the machine state 510.

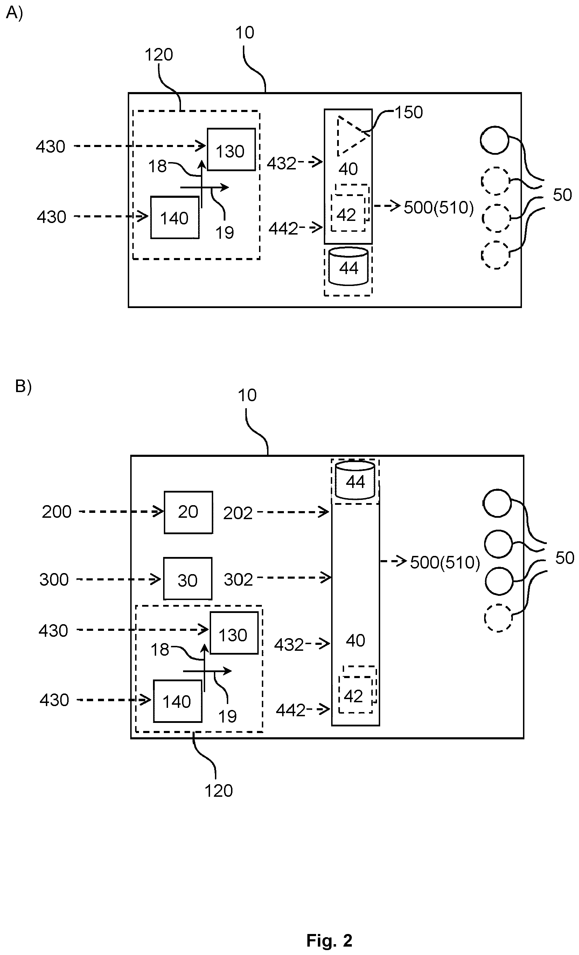

Figure 2 illustrates two embodiments of the sensor device 10 configured for determining the rotation direction of the motor.

Figure 2A illustrates one embodiment of the sensor device 10 comprising a measuring circuit 120 comprising a first sensor element 130 and a second sensor element 140. The sensor elements 130,140 are configured to continuously measure a field 430 from the motor. The field may be continuously measured at set time intervals.

The first and second sensor components are arranged relative to each other in mirror symmetry about the first axis 18 and the second axis 19 as illustrated in the figure. The first axis 18 and the second axis 19 are arranged perpendicular to each other and in a plane comprising the two sensor elements 130,140. Alternatively described but with the same result, the sensor elements may be arranged with 180 degrees rotation symmetry. In that case, the sensor element 130 is rotated 180 degrees away from sensor element 140 in a plane around a centre axis arranged perpendicular to the plane spanned by the first and second axis (18,19).

The first sensor element 130 and the second sensor element 140 are similar sensor types i.e. they are adapted to measure on the same type of field.

The sensor device 10 may furthermore comprise a comparator 150 e.g. implemented as a HW circuit or in the data processor arrangement 40. The comparator may receive input based on the first field signal 432 and based on the second field signal 442 based on the measured field signal 430 measured by the first sensor element 130 and the second sensor element 140, respectively.

The comparator is adapted for determining a time difference or time-of-flight for two field signals 432, 442. The comparator provides an output indicating a rotational direction of the motor based on the time-of-flight.

The sensor device 10 furthermore comprises at least one signalling unit 50 in communication with the comparator. The signalling unit is adapted for indicating the machine state 510 comprised in the output signal 500.

The machine state 510 may in one example simply comprise information of the rotational direction. The machine state may in this example be set to three values: forward, reverse, non-set, or alternatively positive, negative or non-set. A LED as signalling unit 50 may indicate the state by green, red and off. Alternatively, the state may be indicated by a flashing operating of a LED. In yet another alternative embodiment, the transducer may give off acoustic signals or a combination of visible and acoustic signals for indicating the machine state 510.

The symmetry of the sensor elements 130,140 facilitates that the sensor device 10 can be operatively mounted basically independently of the shaft direction of the motor as long as the plane of the sensor elements are not parallel to the rotation plane of the motor and a line going through both sensor elements are not parallel to the motor shaft. The optimal operation may be accomplished by a mounting direction with either the first axis 18 or the second axis 19 arranged parallel to the shaft of the motor and hence any 90 degrees rotation may be optimal. However, the sensor device 10 may be successfully operated when arranged in other slightly tilted directions compared to the shaft. In short, the sensor device must be mounted such that a time difference in the measured signal can be determined.

Figure 2B illustrates another embodiment of the sensor device 10 illustrated in figure 2A. The sensor device in figure 2B furthermore comprises the elements of the embodiment illustrated in figure 1B. Hence, the two embodiments in figure 1B and 2A of the sensor device 10 for monitoring rotational machinery is integrated into a single sensor device 10 as illustrated in figure 2B.

The illustrated embodiment, in addition to that embodiment illustrated in figure 2A furthermore comprises one or more embedded data processors 40. The data processor(s) are adapted for providing at least one output signal 500 comprising information of the determined rotation direction of the motor. Accordingly, the signalling units may be adapted for indicating the validity of the measured fields/signals.

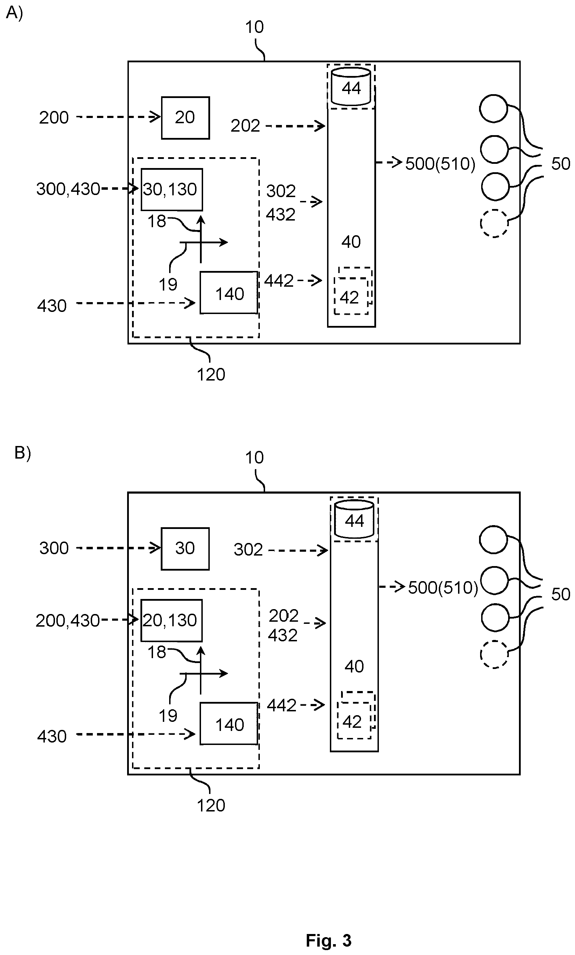

Figure 3 illustrates two embodiments of the sensor device 10 comparable to the embodiment in figure 2B, but wherein in figure 3A the accelerometer 30 is configured as the first sensor element 130 and in figure 3B the magnetic field sensor 20 is configured as the first sensor element 130.

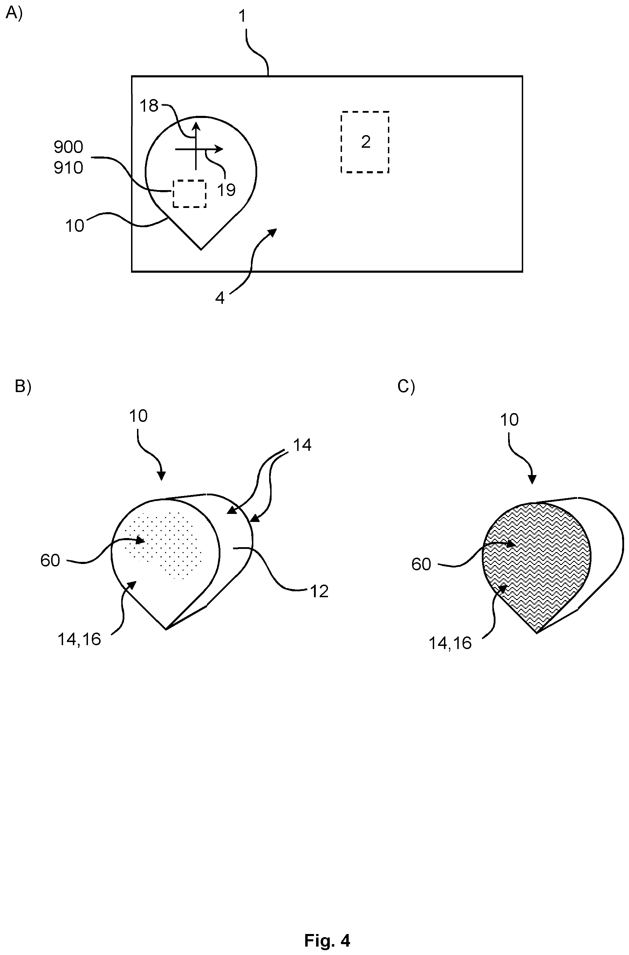

Figure 4 illustrates three embodiments of the sensor device 10. Figure 4A illustrates an embodiment where the sensor device 10 is attached to a surface 4 of the rotational machinery 1 having a motor 2, and hence an embodiment of a rotational machinery 1 comprising the sensor device 10. The sensor device 10 is configured with a first axis 18 and a second axis 19 and comprises a computer-readable medium 910 with stored computer program 900. The stored computer program 900 may comprising instructions to cause the sensor device 10 to execute the steps of the method to be performed using a corresponding sensor device. Hence, the computer program 900 may be adapted to the specific embodiment of the sensor device 10, which may be beneficial for the edge-computing performed in the sensor device 10.

Figure 4B illustrates one embodiment of the sensor device 10 comprising an outer enclosure 12 with an outer surface 14 and configured with a mounting area 16. The sensor device 10 is adapted to be attached onto a surface 4 of the rotational machinery e.g. by using an adhesive 60. The adhesive is applied between the mounting area 16 and the surface 4 of the machinery.

Figure 4C illustrates a sensor device 10 wherein the mounting area 16 comprises a corrugated surface. The corrugated surface enlarges the surface area for improved connection to the rotational machinery for better adhesion and for better transfer of the mechanical vibrations. The corrugated surface may comprise lines, squares, waves, recess, grooves, and indentations, amongst other.

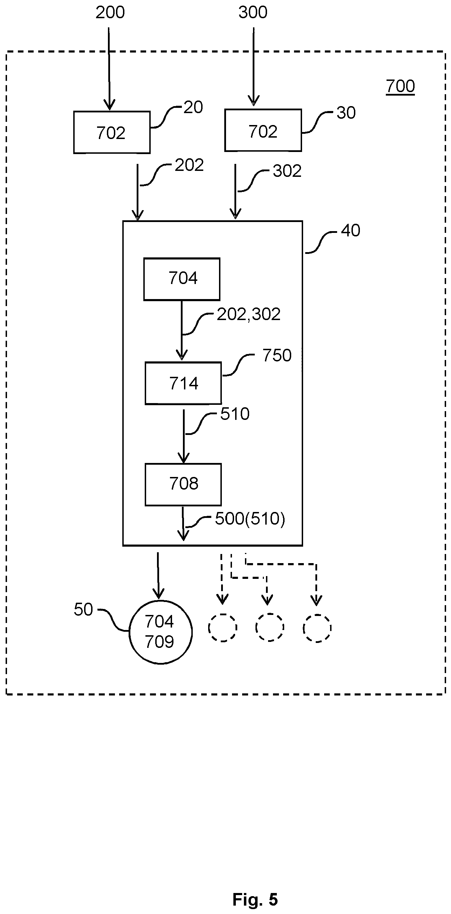

Figure 5 illustrates one embodiment of the method 700 of monitoring rotational machinery.
The illustrated method comprising acts of:
- measuring 702 a magnetic field 200 with the embedded magnetic field sensor 20;
- measuring 702 mechanical vibrations 300 with the embedded accelerometer 30;
- receiving 704 the measured vibration signals 302 and the measured magnetic field signal 202 in the data processor arrangement 40;
- selecting 714 a machine state 510 amongst a provided plurality of machine states 510 based on the received measured magnetic field signal 202 and the received measured vibrational signal 302 according to a predefined set of rules 750;
- providing 708 at least one output signal 500 indicating the selected machine state 510, and
- indicating 709 the selected machine state 510 with one of the one or more signalling units 50 based on the output signal 500 comprising the selected machine state.

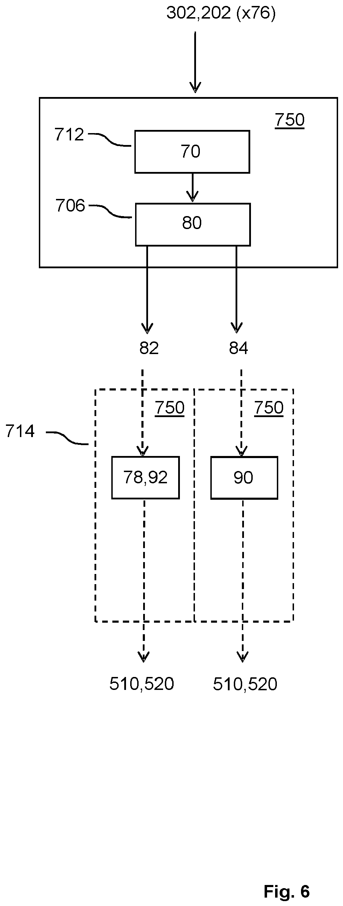

Figure 6 illustrates different embodiments of predefined sets of rules 750 comprised in the method 700 of monitoring rotational machinery.

One embodiment of a predefined set of rules 750 is illustrated by the upper solid-line box wherein multiple measured signals is transformed into and analysed in the frequency domain. The set of rules 750 is illustrated for the measured signals being respectively the measured magnetic field signals 202 and the measured vibration signals 302. The rules comprise acts of:
- transforming 712 the measured signal from time domain to frequency domain by Fourier transformation; and
- in the frequency domain and within the set rotational speed range 70, determining 706 a global peak point 80 being a point with a magnitude greater that the magnitude of any other points in the signal.
The signal within a set rotational speed range 70 is analysed. The rotational speed range 70 may be set differently for each of the received signals i.e. it may be adjusted and set for a single received signal.

Other embodiment of predefined set of rules 750 is illustrated by the lower dashed line boxes, wherein a machine state 510 is selected 714 based on a validity 520 of a peak frequency 82, a peak amplitude 84 or a steady operation. The steady operation is evaluated based on a number 76 of received measured signals indicated by the inserted '(x76)' for the input signals to the method and thus the illustrated set of rules 750.

The peak frequency 82 of the global peak is evaluated in regard to a frequency deviation 78 and further for the received measured vibrational signal a frequency slip 92. The peak amplitude 84 of the global peak 80 is evaluated in regard to a threshold amplitude level 90.

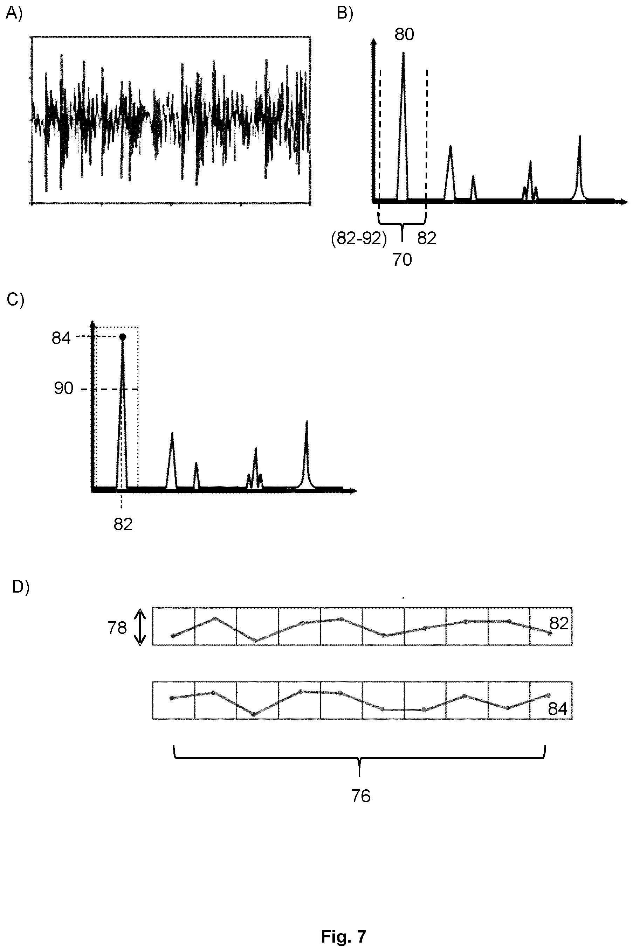

Figure 7 illustrates exemplary examples of measured and analysed signals. Figure 7A illustrates a signal in the time domain. The signal may be interpreted to comprise one or more periodic signature.

Figure 7B illustrates the signal in the frequency domain. The signal comprises multiple peaks. The first peak is the global peak point 80 in the signal, as this peak has a magnitude greater that the magnitude of any of the other points in the pre-set rotational speed range 70. In case the signal is a vibrational signal, the predefined rules include that the global peak 80 should be within a set rotational speed range 70 set by a maximum being a peak frequency, F_{PEAK} 82 of a magnetic signal and a minimum being the peak frequency, F_{PEAK} 82 of a magnetic signal minus a set frequency slip 92.

Figure 7C illustrates the peak frequency F_{PEAK} 82 of the global peak point 80 and the peak amplitude 84 of the global peak point 80. For each signal to be used for determining the rotational or vibrational state, the global peak point 80 are located and the peak frequency F_{PEAK} 82 and the peak amplitude A_{PEAK} 84 may be determined. The global peak is validated by the peak amplitude A_{PEAK} 84 being above a set threshold amplitude level 90.

Figure 7D illustrates how the peak frequency, F_{PEAK} 82 and the peak amplitude, A_{PEAK} 84 of the global peak points 80 may be validated and how an initial steady operation may be validated. I.e. for a number 76 of measured signals, the peak frequency 82 of the global peaks of all the measurements comprised in the number of measurements 76 should be within an allowed frequency deviation 78 of each other.

A further evaluation may include that the peak amplitude 84 of the global peaks of all the measurements comprised in the number of measurements 76 should be above a set threshold amplitude level 90. Alternatively, a further evaluation includes an average peak amplitude being an average value of the global peaks of all the measurements comprised in the number of measurements 76, defining the setting of the maximum determined peak amplitude found in the initial condition step and based thereon setting the threshold amplitude level 90 as being a fixed share of the maximum determined peak amplitude found in the initial condition step.

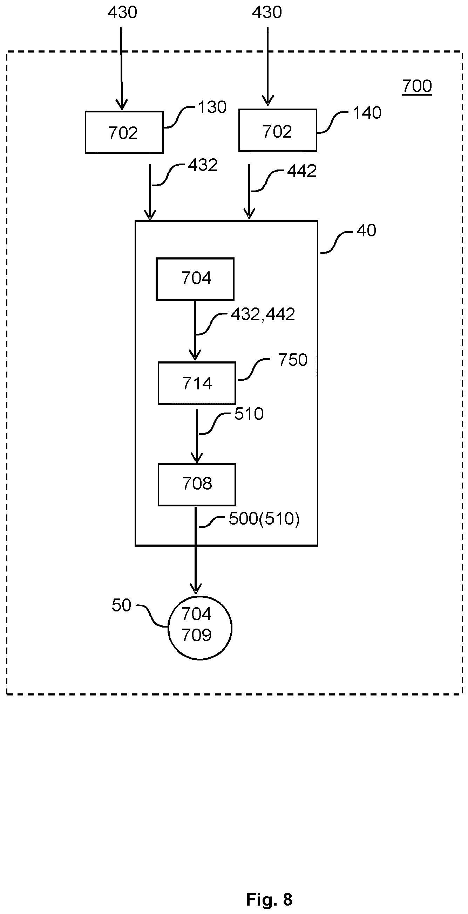

Figure 8 illustrates one embodiment of the method 700 of monitoring rotational machinery using the alternative sensor device. The method comprises acts of:
- measuring 702 a field 430 with the first sensor element 130 and with the second sensor element 140;
- receiving 704 the measured first field signal 432 provided by means of the first sensor element 130 and the measured second field signal 442 provided by the second sensor element 140 in the data processor arrangement 40;
- selecting 714 a machine state 510 amongst a provided plurality of machine states based on the received measured first field signal 432 and the received measured second field signal 442 according to a predefined set of rules 750;
- providing 708 an output 500 from the data processor arrangement 40, said output 500 indicating the selected machine state 510;
- receiving 704 in one or more of the one or more signalling units (50) said output 500 provided by the data processor arrangement 40, and
- indicating 709 the selected machine state 510 by means of one or more visual and/or audio signals based on said output 500 using one or more of the one or more signalling units 50.

## Claims

1. A sensor device (10) for monitoring rotational machinery (1) having a motor (2) comprising a rotor and a stator when attached thereto, said sensor device (10) comprising:
- an outer enclosure (12) with an outer surface (14);
- a measuring circuit (120) comprising a first sensor element (130) and a second sensor element (140) configured to measure a field (430) during rotation of the rotor;
- a data processor arrangement (40) comprising one or more data processors (42) and being configured to be in communication with the measuring circuit (120) for receiving measured first field signals (432) provided by means of the first sensor element (130) and measured second field signals (442) provided by means of the second sensor element (140);
- one or more signalling units (50) in communication with the data processor arrangement (40),
wherein said data processor arrangement (40), said measuring circuit (120) and said one or more signalling units (50) are enclosed by the outer enclosure (12),
wherein said data processor arrangement (40) is configured for processing input based on the measured first and second field signals (432,442) according to a predefined set of rules (750), and configured to provide an output (500) based on said processing, said output (500) indicating a machine state (510) selected amongst a plurality of machine states,
wherein said one or more signalling units (50) are configured for reflecting the selected machine state (510) by means of one or more visual and/or audio signals based on said output (500) based on the output (500) provided by the data processor arrangement (40),
wherein the first sensor element (130) and the second sensor element (140) are adapted to measure on the same field type and are arranged in mirror symmetry about a first axis (18) and a second axis (19) being perpendicular to the first axis (18).

2. The sensor device (10) according to claim 1, wherein the first and second sensor elements (130,140) both comprises an accelerometer, a coil, a hall element or a microphone.

3. The sensor device (10) according to claim 1, wherein the first and second sensor elements (130,140) are arranged in one plane comprising the first axis (18) and the second axis (19).

4. The sensor device (10) according to any one or more of the preceding claims further comprising:
- a magnetic field sensor (20) configured for measuring a magnetic field (200) during rotation of the rotor;
- an accelerometer (30) configured for measuring mechanical vibrations (300) during rotation of the rotor;
wherein said accelerometer (30) and said magnetic field sensor (20) are enclosed by the outer enclosure (12),
wherein the data processor arrangement (40) is further configured to be in communication with the accelerometer (30) for receiving measured vibration signals (302) provided by means of the accelerometer (30) and to be in communication with the magnetic field sensor (20) for receiving measured magnetic field signals (202) provided by means of the magnetic field sensor (20), and for processing input further based on the measured magnetic field signal (202) and the measured vibrational signal (302) according to the predefined set of rules (750).

5. The sensor device (10) according to claim 4, wherein the magnetic field sensor (20) is configured as the first sensor element (130) or the second sensor element (140), or the accelerometer (30) is configured as the first sensor element (130) or the second sensor element (140).

6. The sensor device (10) according to any one or more of the preceding claims configured with a mounting area (16) arranged on the outer surface (14) adapted for being attached onto non-modified surface (4) of the rotational machinery (1) using an adhesive (60).

7. The sensor device (10) according to claim 6, wherein the mounting area (16) comprises a corrugated surface configured for enlarging the surface area of the mounting area (16).

8. A method (700) of monitoring a rotational machinery (1) having a motor (2) comprising a rotor and a stator using a sensor device (10) attached to said rotational machinery (1), wherein said method (700) comprises acts of:
- during rotation of the rotor, measuring (702) a field (430) with a first sensor element (130) and a second sensor element (140);
- receiving (704) measured first field signals (432) provided by means of the first sensor element (130) and measured second field signals (442) provided by the second sensor element (140) in a data processor arrangement (40);
- selecting (714) a machine state (510) amongst a plurality of machine states based on the received measured first field signal (432) and the received measured second field signal (442) according to a predefined set of rules (750);
- providing (708) an output (500) from the data processor arrangement (40), said output (500) indicating the selected machine state (510);
- receiving (704) in one or more signalling units (50) said output (500) provided by the data processor arrangement (40), and
- indicating (709) the selected machine state (510) by means of one or more visual and/or audio signals based on said output (500) using one or more of the one or more signalling units (50), and
wherein the sensor device (10) is arranged with a first axis (18) being parallel to a rotational plane of the rotor and a second axis (19) being arranged non-parallel to the rotational plane of the rotor, and wherein the first sensor element (130) and the second sensor element (140) are arranged in mirror symmetry about the first axis (18) and the second axis (19) being perpendicular to the first axis (18).

9. The method (700) according to claim 8, wherein the predefined set of rules (750) includes a determined rotation direction of the motor (2), wherein said rotation direction is determined by comparing the time order of reception in the data processor arrangement (40) of the received measured first field signal (432) and the received measured second field signal (442).

10. The method (700) according to any one of claims 8-9, comprising further acts of:
- during rotation of the rotor, measuring (702) a magnetic field (200) with a magnetic field sensor (20);
- during rotation of the rotor, measuring (702) mechanical vibrations (300) with an accelerometer (30);
- receiving (704) the measured magnetic field signals (202) and the measured vibration signals (302) in the data processor arrangement (40);
- selecting (714) a machine state (510) amongst the plurality of machine states further based on the received measured magnetic field signal (202) and the received measured vibrational signal (302) according to the predefined set of rules (750).

11. The method (700) according to claim 10, wherein the predefined set of rules (750) comprises finding a global peak point (80) and determining a peak frequency, F_{PEAK} (82) and a peak amplitude, A_{PEAK} (84) of the global peak point (80) for a received measured signal within a set rotational speed range (70) by:
- transforming (712) the measured signal from time domain to frequency domain by Fourier transformation, and
- in the frequency domain and within the pre-set rotational speed range (70), determining (706) a global peak point (80) being a point with a magnitude greater than the magnitude of any other points within the set rotational speed range (70), wherein the received measured signals are received measured magnetic field signals (202) and/or the received measured vibrational signals (302).

12. The method (700) according to claim 11, wherein the predefined set of rules (750) comprises an initial condition of validating a steady operation of the rotational machinery using a number (76) of received measured magnetic field signals (202) and of received measured vibrational signals (302), wherein the operation of the rotational machinery is set to steady if:
- the determined peak frequency, F_{PEAK} (82) of the global peak point (80) for each of the received measured magnetic field signals (202) are within an allowed frequency deviation (78);
- the determined peak frequency, F_{PEAK} (82) of the global peak point (80) for each of the received measured vibrational signals (302) are within an allowed frequency deviation (78), and
- the determined peak frequency, F_{PEAK} (82) of the global peak point (80) for each of the received measured vibrational signals (302) are within an allowed frequency slip (92) of one or more of the determined peak frequency, F_{PEAK} (82) of the global peak point (80) for each of the received measured magnetic field signals (202).

13. The method (700) according to claims 12, wherein the act of indicating (709) the selected machine state (510) includes using at least one signalling unit (50) for indicating a rotational direction of the motor (2), and wherein the machine state is set to one of at least two values comprising non-determined or positive, wherein the value is set to:
- positive when a steady operation of the rotational machinery has been validated, and
- non-determined otherwise.

14. The method according to any one or more of claims 8-13 wherein the monitoring of the rotational machinery comprises using the sensor of any one or more of claims 1-7.

15. A rotational machinery (1) having a surface (4) and a motor (2) comprising a rotor and a stator, said machinery (1) comprising the sensor device (10) according to any one or more of claims 1-7 attached to the surface (4) and adapted to perform the method (700) according to any one or more of claims 8-13.
